# EUROPEAN PATENT APPLICATION

(11) **EP 1 505 653 A1**
(43) Date of publication of application: **09.02.2005**
(21) Application number: 03425532.3
(22) Date of filing: 04.08.2003
(51) Int. Cl.: H01L 27/115

(54) **Layout method for dummy structures and corresponding integrated circuit**

(71) Applicant: STMicroelectronics S.r.l., 20041 Agrate Brianza MI (IT)
(72) Inventor: Cappelletti, Paolo Giuseppe, 20030 Seveso (Milano) (IT); Maurelli, Alfonso, 20050 Sulbiate (Milano) (IT); Zabberoni, Paola, 20052 Monza (Milano) (IT)
(74) Representative: Ferrari, Barbara

(57) **Abstract**

A method for manufacturing electrically non-active structures of an electronic circuit integrated on a semiconductor substrate (5) comprising first electrically active structures (6) and second electrically active structures (7), comprising the steps of:
- inserting, in the electronic circuit, electrically non-active structures (8) to uniform the surface of the electronic circuit, the method being characterised in that it comprises the following further steps:
- identifying, between the electrically non-active structures (8), a first group (9) of electrically non-active structures adjacent to the first (6) and second (7) electrically active structures,
- identifying, between the electrically non-active structures (8), a second group (10) of electrically non-active structures not adjacent to the first (6) and second (7) electrically active structures,
- defining, on the semiconductor substrate, the first (9) and second (10) group of electrically non-active structures through different photolithographic steps.

## Description

### Field of application

The present invention relates to a method for manufacturing electrically non-active structures in order to optimise the definition of electrically active structures in an electronic circuit integrated on a semiconductor substrate and corresponding circuit.

More specifically, the invention relates to a method for manufacturing electrically non-active structures of an electronic circuit integrated on a semiconductor substrate comprising first electrically active structures and second electrically active structures.

The invention also relates to an electronic circuit integrated on a semiconductor substrate comprising first electrically active structures, second electrically active structures, as well as electrically non-active structures to uniform the surface of said electronic circuit.

The invention particularly, but not exclusively, relates to a method for defining electrically non-active structures in order to optimise the definition of electrically active structures such as non volatile memory cells, and the following description is made with reference to this field of application for convenience of illustration only.

### Prior art

As it is well known, when designing electronic circuits integrated on a semiconductor substrate, manufactured in submicrometric CMOS technologies, the insertion of electrically non-active service structures is more and more necessary, these structures being commonly and hereinafter defined as "dummy" structures, whose only scope is to provide an improved definition, during the manufacturing process, of the electrically active components of an integrated circuit.

These dummy structures, provided in the manufacturing steps of integrated circuits being considered as critical for a predetermined technology, allow to increase the more or less local density of electrically active structures, which must be integrated on a same semiconductor substrate. In fact, these dummy structures, manufactured with semiconductor elements projecting from the semiconductor substrate, having for example a polygonal section, considerably reduce size and shape differences between electrically active structures located at the edges of very structure-dense circuit areas and those located inside said areas.

Moreover, the use of layer removal techniques by means of circuit-structure-morphology-sensitive tools, such as CMP (Chemical Mechanical Polishing), further makes the insertion of dummy structures necessary, since the presence of these dummy structures also helps to reduce altimetric differences between more or less dense areas of electrically active components as much as possible.

As it is known to the skilled in the art, in order to define a plurality of circuit structures on a semiconductor substrate, a photo-resist material mask is formed on this semiconductor substrate, wherein the geometry of the circuit structures to be manufactured, generally defined as layout, is etched.

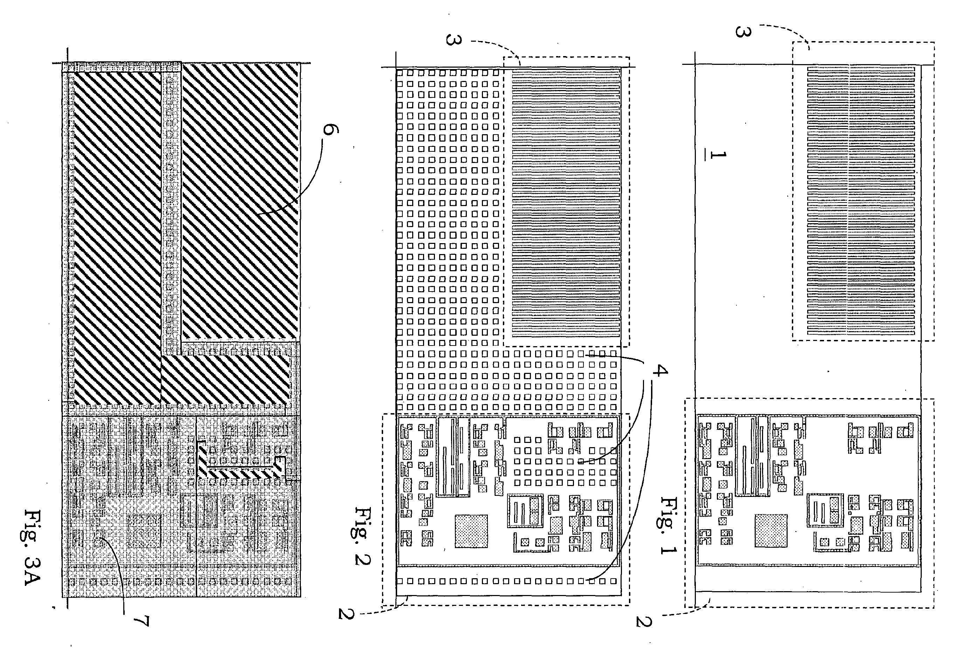

A circuit layout, which does not provide the use of dummy structures at the active area level is shown in figure 1 as non limiting, illustrative example.

In particular figure 1 shows a photo-resist material mask 1 quoting the geometries of active areas of an electronic circuit to be manufactured on a semiconductor substrate. In particular, this electronic circuit comprises a first portion 3 integrating a FLASH memory matrix and a second portion 2 integrating the corresponding circuitry.

As it is known a FLASH memory matrix comprises a plurality of electrically active structures, for example floating gate MOS transistors, while the circuitry comprises, for example, conventional MOS transistors.

In order to uniform the structures provided on the semiconductor substrate, a plurality of active areas is also provided in the layout, i.e. substrate portions delimited by field oxide, to manufacture a plurality of dummy structures 4, as shown in figure 2.

The layout of these dummy structures 4 almost always occurs automatically, on the basis of technology indications, exploiting software tools commonly used by the skilled in the art.

Although advantageous under several aspects, this solution has several drawbacks.

In fact the more and more excessive integration of electronic components on a same semiconductor substrate 1 requires a dedicated optimisation of some process steps being necessary to manufacture the electrically active structures forming electronic components, and thus it sometimes requires the definition "split" of a predetermined manufacture level of these structures. This implies that different photolithographic masks are used to define different circuit portions to be manufactured on a same semiconductor substrate.

For example, in the case of the circuit layout shown in figure 2, when the sizes of electrically active cells are reduced, the definition of the active areas of these structures of the Flash cell matrix and of the circuitry requires the use of two different photolithographic masks, in order to form insulation layers, different in thickness.

Since Flash memory cell matrixes are formed by dense structures, i.e. particularly close to each other, and they are generally already drawn with dummy structures, particularly dummy cells, in order to take into consideration some photolithographic definition edge effects, the active areas of dummy structures 4 being provided on the semiconductor substrate 1, when generating masks, are associated to the circuitry electrically active structures.

Thus, when the size of electrically active structures is reduced, the need to optimise the definition of the active areas of very dense electrically active structures with respect to less dense ones is increasingly felt.

Nevertheless, when the memory matrix area portion is proportionally a negligible fraction with respect to the sizes of the whole electronic circuit, some process problems can occur with the presently available tools and equipment making it impossible to define correctly the active matrix area.

The technical problem underlying the present invention is to provide a method for defining dummy structures providing an optimum distribution of these dummy structures during the definition step with respect to electrically active structures, having such features as to allow the manufacture of these electrically active structures to be more effective in order to overcome the limits and/or drawbacks still affecting the manufacture of devices according to prior art.

### Summary of the invention

The solution idea underlying the present invention is to provide dummy structures being automatically generated in the layout of an integrated circuit comprising first electrically active structures and second electrically active structures, to identify a first group of dummy structures being adjacent to the electrically active structures and a second group of more inner dummy structures, i.e. not directly "facing" electrically active structures and then to define these two groups of dummy structures through two distinct manufacturing steps.

Advantageously, the first electrically active structures are very "dense" while the second electrically active structures are little "dense".

Advantageously, the first group of dummy structures is simultaneously defined with the second electrically active structures, while the second group of dummy structures is simultaneously defined with the first electrically active structures.

On the basis of this solution idea the technical problem is solved by a method as previously indicated and defined in the characterising part of claim 1.

The features and advantages of the method according to the invention will be apparent from the following description of an embodiment thereof given by way of indicative and non-limiting example with reference to the attached drawings.

### Brief description of the drawings

In these drawings:
- Figure 1 shows an example of an integrated circuit layout, at the active area level, comprising a Flash non volatile memory matrix portion and a circuitry portion,
- Figure 2 shows the layout of the circuit of figure 1 after generation of dummy structures according to the prior art,
- Figure 3A shows the layout of figure 2 wherein two different active area zones are identified, which are defined by two different photolithographic masks according to the present invention,
- Figure 3B shows the layout of figure 3A wherein only dummy structures are highlighted,
- Figure 4 shows a first layout to define a first group of active areas of the dummy structures and of the circuitry according to the present invention,
- Figure 5 shows a second layout to define a second group of active areas of the dummy structures and of the matrix according to the present invention,
- Figure 6 shows a view from above and the cross-section view along the line I-I of two portions of a semiconductor substrate wherein dummy structures manufactured according to the method of the invention are integrated.

### Detailed description

The process steps described hereinafter do not form a complete process flow for manufacturing integrated circuits. The present invention can be implemented together with the integrated circuit manufacturing techniques presently used in this field and only those commonly used process steps which are necessary to understand the invention are included in the description.

The figures representing cross sections of integrated circuit portions during the manufacturing are not drawn to scale, but they are drawn instead in order to show the important features of the invention.

With reference to these figures, a method for manufacturing electrically non-active structures is described, in order to optimise the definition of electrically active structures inside an electronic circuit integrated on a semiconductor substrate 5.

In particular, only by way of example, a method for generating active area masks for embedded Flash memories is described in the 0.13 um generation.

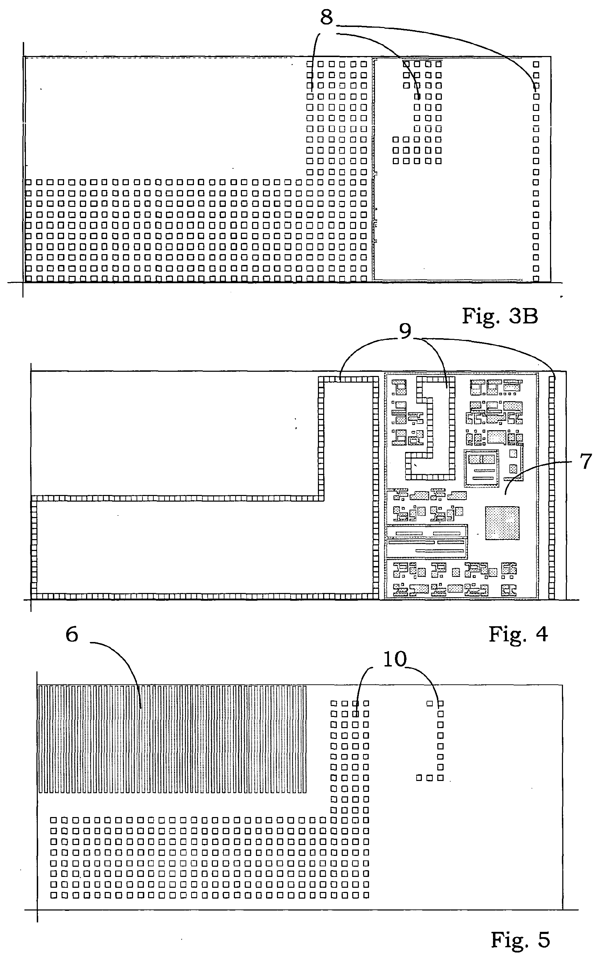

In particular, with reference to figures 3A and 3B, a photolithographic mask is shown, wherein the geometrical structures for forming the active areas of circuit structures of an electronic circuit are etched.

In particular, this electronic circuit comprises a first portion 6 wherein first electrically active structures are integrated, such as for example a FLASH memory cell matrix, and a second portion 7 wherein electrically active structures are integrated, such as for example MOS transistors, diodes, resistors or capacitors of a circuitry associated to the matrix.

Advantageously, the first electrically active structures are very close or dense, while the second electrically active structures are not so close to each other or little "dense".

As already mentioned with reference to the prior art, electrically non-active or dummy structures 8 are inserted in the integrated circuits. The step of identifying the positions wherein these electrically non-active structures 8 are manufactured in the integrated circuit usually occurs by analysing the electrically active structures of the integrated circuit, the following calculation (layer by layer of the drawing) of the density of the electrically active structures on the semiconductor substrate 5. If this density is lower than the technology set value, the automatic insertion of these dummy structures 8 is provided inside the circuit empty portions, in order to reach a desired density.

In the method according to the invention, a first group 9 of dummy structures adjacent to the electrically active structures shown in figure 4 as well as a second group 10 of more inner dummy structures, i.e. not directly "facing" the electrically active structures shown in figure 5, are identified. Advantageously according to the invention, these two groups 9, 10 of dummy structures are then defined through two different steps.

Advantageously, this first group 9 of dummy structures has the form of closed polygons, as shown in figure 4.

Advantageously, this step of identifying these first 9 and second 10 groups of dummy structures occurs through simple boolean operations.

Advantageously, the first group 9 of dummy structures is defined, when preparing the masks, simultaneously with the second electrically active structure 7, while the second group 10 of dummy structures is simultaneously defined with the first electrically active structures 6, through a mask shown in figure 5.

Therefore, in the case of the shown example, with a particular composition of the set of masks shown in figures 4 and 5, the transmittance, i.e. the enlighten area at the photolithographic exposure time, in Flash matrix areas goes from a value much lower than 7% of the mask 1 of figure 1, which is not suitable at all for the correct definition of structures 3 of the "dense" type, to a value near 30%, while the same value decreases from 50% to 35% in correspondence with the circuitry area 2.

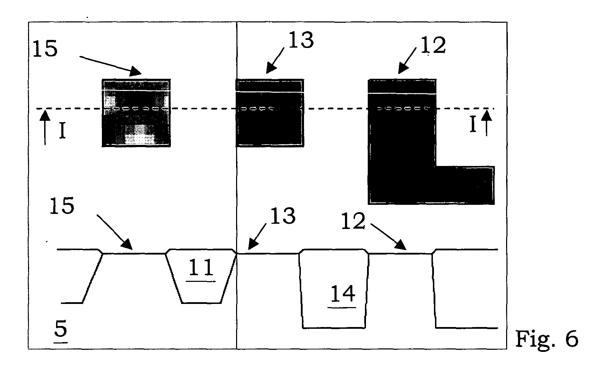

With reference to figure 6, a plurality of active areas is shown, obtained with the method according to the invention.

In particular, on a semiconductor substrate 5, through a conventional photolithographic process using the mask of figure 4, active areas 12 and 13 are defined, wherein the electrically active circuitry structures 7 and the first group 9 of dummy structures are respectively integrated, each active area 12, 13 being insulated from the adjacent area by means of an insulating layer 14 of a first thickness.

On the same semiconductor substrate 5, through a conventional photolithographic process using the mask of figure 5, the electrically active matrix structures 6 and the second group 10 of dummy structures are then defined in respective active areas 15, each active area 15 being insulated from the adjacent area by means of an insulating layer 11 of a second thickness.

Active areas 13 adjacent to the circuitry 7 have then the same structural features of the circuitry active area 12, while active areas 15 which are not adjacent to electrically active structures have the same features of the matrix active areas 6.

In the description, reference has been made to first dense electrically active structures and second little dense electrically active structures. It is however possible for the method according to the invention to be similarly applied to first electrically active structures having a final size different from the second electrically active structures.

In conclusion, the method according to the invention allows dummy structure 8 to be differentially defined, at the mask manufacturing and subsequent manufacturing on a semiconductor substrate level, in order to define most of these structures 10 at the same time as the definition of the matrix active area 6, but without compromising the correct manufacturing of circuitry active areas 12.

Advantageously, being the first group 9 of electrically non-active structures, those adjacent to the first 6 and second 7 electrically active structures, in the form of a closed polygon, a possible misalignment between the masks is prevented from causing a double trench in the oxide layer 11.

In the description, reference has been made to the definition of the active areas of electrically active and non-active structures, the method according to the invention being however applicable to different elements of the electrically active and non-active structures, whose definition requires photolithographic steps such as for example the definition of gate electrodes.

## Claims

1. A method for manufacturing electrically non-active structures of an electronic circuit integrated on a semiconductor substrate (5) comprising first electrically active structures (6) and second electrically active structures (7), comprising the steps of:
- inserting, in said electronic circuit, electrically non-active structures (8) to uniform the surface of said electronic circuit, the method being **characterised in that** it comprises the following further steps:
- identifying, among said electrically non-active structures (8), a first group (9) of electrically non-active structures adjacent to said first (6) and second (7) electrically active structures,
- identifying, among said electrically non-active structures (8), a second group (10) of electrically non-active structures not adjacent to said first (6) and second (7) electrically active structures,
- defining, on said semiconductor substrate, said first (9) and second (10) group of electrically non-active structures through different photolithographic steps.

2. A method for manufacturing electrically non-active structures according to claim 1, **characterised in that** said first group (9) of electrically non-active structures is defined together with said second electrically active structures (7).

3. A method for manufacturing electrically non-active structures according to claim 1, **characterised in that** said second group (10) of electrically non-active structures is defined together with said first electrically active structures (6).

4. A method for manufacturing electrically non-active structures according to claim 1, **characterised in that** said first electrically active structures (6) are formed by floating gate transistors of a matrix of non volatile memory cells.

5. A method for manufacturing electrically non-active structures according to claim 1, **characterised in that** said second electrically active structures (7) comprise MOS transistors of a circuitry associated to a matrix of non volatile memory cells.

6. A method for manufacturing electrically non-active structures according to claim 1, **characterised in that** said electrically non-active structures (8) are formed by semiconductor elements projecting from the substrate.

7. A method for manufacturing electrically non-active structures according to claim 1, **characterised in that** said first electrically active structures (6) are close to each other and said second electrically active structures (7) are spaced from each other.

8. An electronic circuit integrated on a semiconductor substrate (5) comprising first electrically active structures (6), second electrically active structures (7), as well as electrically non-active structures (8) to uniform the surface of said electronic circuit, **characterised in that** said electrically non-active structures (8) comprise a first group (9) of electrically non-active structures adjacent to said first (6) and second (7) electrically active structures and in the form of a closed polygon.

9. An electronic circuit according to claim 8, **characterised in that** said first electrically active structures (6) are close to each other and **in that** said second electrically active structures (7) are spaced from each other.

10. An electronic circuit according to claim 8, **characterised in that** said electrically non-active structures (8) comprise a second group (10) of electrically non-active structures comprised in said first group (9) of electrically non-active structures.

11. An electronic circuit according to claim 10, **characterised in that** said first electrically active structures (6) are floating gate transistors of a matrix of non volatile memory cells, said second electrically active structures (7) comprising MOS transistors of a circuitry associated to said matrix of non volatile memory cells, said first (6) structures being manufactured in active areas insulated by means of a layer (11) of a first thickness, said second (7) structures being manufactured in active areas (12) insulated by means of a layer (14) of a second thickness wherein said first group (9) is manufactured in active areas (13) insulated by means of said layer (14) of a second thickness and said second group (10) is manufactured in active areas (15) insulated by means of said layer (11) of a first thickness.
